# EUROPEAN PATENT APPLICATION

(11) **EP 1 156 511 A1**
(43) Date of publication of application: **21.11.2001**
(21) Application number: 01111448.5
(22) Date of filing: 10.05.2001
(51) Int. Cl.: H01J 37/32, C23C 16/452

(54) **Remote plasma CVD apparatus**

(30) Priority: 19.05.2000 US 574401
(71) Applicant: Applied Materials, Inc., Santa Clara, California 95054 (US)
(72) Inventor: Nowak, Thomas, Cupertino, California 95014 (US); Tanaka, Tsutomu (Tom), Santa Clara, California 95051 (US); Fairbairn, Kevin, Los Gatos, California 95032 (US)
(74) Representative: Kirschner, Klaus Dieter, Dipl.-Phys.

(57) **Abstract**

A method and apparatus for presenting processing fluids, such as a flow of ions, into a process chamber to facilitate deposition of layers on a substrate featuring a dual remote plasma source coupled to deliver two flows of reactive radicals to a chemical vapor deposition process chamber, while maintaining separation of the two flows until reaching a process region proximate to the substrate.

## Description

The present invention relates to substrate processing. More specifically, the present invention relates to apparatuses and methods for depositing or etching layers of films on a substrate in a substrate processing apparatus. Some embodiments of the present invention may be useful for cleaning a process chamber in the substrate processing apparatus.

One of the primary operational characteristics of modern semiconductor substrate processing apparatuses is the formation of various layers on a substrate surface. Examples of the various layers include dielectrics, such as silicon nitride (Si₃N₄) and amorphous silicon, Siₓ, while other layers are conductive, such as tungsten silicide (WSiₓ), or titanium nitride (TiN). As is well known, such layers can be deposited by chemical vapor deposition (CVD). In a conventional thermal CVD process, reactive gases are supplied to the substrate surface where heat-induced chemical reactions take place to form the desired film over the surface of the substrate being processed. Were a deposition process to require multiple reactive gases, such as Si₃H₄ and N₂ to form Si₃N₄ or TiCl₄ and NH₃ to form TiN; the gases are usually combined within a mixing chamber that is then coupled via a conduit to a showerhead located in a process chamber. For example, in the deposition of a silicon nitride layer, the two reactive gases are supplied to a mixing chamber along with their respective carrier gases of helium and hydrogen. In the mixing chamber the reactive and carrier gases are combined to form a deposition gas mixture. The deposition gas mixture is then directed through a conduit to a distribution plate, where the plate contains a plurality of holes such that the deposition gas mixture is evenly distributed into the process region of the process chamber. As the deposition gas mixture enters the process region and is infused with thermal energy, a chemical reaction occurs between the silane and the molecular nitrogen (i.e., SiH₄ is reduced by N₂) to produce silicon nitride.

Recent improvements in thermal CVD processes have included maintaining separation of the differing reactive gases that are present in the deposition gas until reaching a process region located proximate to the substrate upon which a layer is to be formed. As a result, accumulation of unwanted deposition and etching of the process chamber and delivery components, such as conduits, is reduced as discussed in United States Patent number 5,595,606 which discloses a showerhead that functions to maintain the separation of two reactive gases until reaching a process region in a process chamber.

For some CVD processes it has been found advantageous to reduce the temperature at which deposition occurs. To that end, conventional plasma-enhanced CVD (PECVD) processes have been developed. In a conventional PECVD process, controlled plasma formed in situ within the process chamber. The plasma is formed using radio frequency (RF) energy to decompose and/or energize reactive species in reactant gases to produce the desired film layer.

Recently, remote plasma sources have been used in some applications to deposit stable layers at lower temperatures with less damage done to existing layers on the substrate as compared to in situ PECVD processes. It is believed that the presence of electric fields produced by an in situ plasma proximate to the substrate may damage the underlying layer. Moreover, it is believed that the close proximity of the plasma and substrate increases the presence of hydrogen in layers formed by some in situ PECVD processes. The remote plasma source avoids the aforementioned problems by allowing a plasma to be formed away from the process chamber. In addition, remote plasma sources are favored over in situ plasma sources in some processes for removing unwanted deposits in a process chamber. This is due to the high breakdown efficiency with a microwave plasma. A drawback of current remote plasma source technology is that typically, reactive radicals produced from multiple reactive gases are mixed before entering the process chamber, resulting in, for example, accumulation of undesired deposits throughout the semiconductor processing apparatus, including the conduits through which the reactive radicals travel towards the process chamber.

What is needed, therefore, is a remote plasma source that facilitates deposition of a layer on a substrate while reducing unwanted deposits in a semiconductor processing apparatus.

The present invention provides a method and apparatus for depositing layers on a substrate and features a dual remote plasma source coupled to deliver two flows of reactive radicals while maintaining separation of the two flows until they reach a process region proximate to the substrate. The method of the present invention includes forming first and second plasmas remotely with respect to the process chamber. The first plasma has a first plurality of reactive radicals associated therewith, and the second plasma has a second plurality of reactive radicals associated therewith. The first and second pluralities of reactive radicals are flowed into the process chamber, with the first group of reactive radicals defining a first flow and the second group of reactive radicals defining a second flow. Mixing of the first and second flows occurs after the reactive radicals have entered the process chamber.

The deposition apparatus includes a process chamber having an intake port and an entry aperture. A source of a first plasma having a first plurality of reactive radicals is in fluid communication with the process chamber. A source of a second plasma having a second plurality of reactive radicals is in fluid communication with the process chamber. A pump system, in fluid communication with both the source of the first plasma and the source of the second plasma, is connected to create first and second flows. The first flow includes the first plurality of reactive radicals, and the second flow includes the second plurality of reactive radicals. A waveguide system is in fluid communication with both the intake port and the entry aperture, and a fluid distribution system is in fluid communication with the waveguide system.

These and other embodiments of the present invention, as well as its advantages and features are described in more detail in conjunction with the text below and attached figures.
Fig. 1 is a vertical, cross-sectional view of a substrate processing apparatus in accordance with the present invention;
Fig. 2 is a top plan view of a first fluid distribution plate included in a showerhead shown above in Fig. 1;
Fig. 3 is a top plan view of a second fluid distribution plate included in a showerhead shown above in Fig. 1;
Fig. 4 is a partial cross-sectional view of the first fluid distribution plate shown above in Fig. 2 and taken along lines 4-4;
Fig. 5 is a detailed view of the first fluid distribution plate shown above in Fig. 2;
Fig. 6 is a cross-sectional view of the detailed view shown above in Fig. 5 and taken along lines 6-6;
Fig. 7 is a partial cross-sectional view of the second fluid distribution plate shown above in Fig. 3 and taken along lines 7-7;
Fig. 8 is a detailed cross-sectional view of a portion of the second fluid distribution plate shown above in Fig. 7 and taken along line 8-8;
Fig. 9 depicts a detailed cross-sectional view of the assembled portions of the lower and upper gas distribution plates forming a faceplate for the showerhead of the present invention;
Fig. 10 is a vertical cross-sectional view of the substrate processing apparatus shown above in Fig. 1 and coupled to a controller and a supply of reactive fluids;
Fig. 11 is a simplified plan view of a dual remote plasma source coupled to the substrate processing apparatus shown above in Figs. 1 and 10, in accordance with the present invention;
Fig. 12 is a cross-sectional side lengthwise view of a remote microwave plasma source module employed in the dual remote plasma source shown above in Fig. 11;
Fig. 13 is a cross-sectional side transverse plan view of a remote microwave plasma source module shown above in Fig. 12, taken along lines 13-13;
Fig. 14 is a cross-sectional side transverse plan view of an alternate embodiment of the remote plasma source shown above in Fig. 13;
Fig. 15 is an alternate embodiment of a plasma applicator shown in Fig. 6;
Fig. 16 is a plan view of an alternate embodiment of a first end wall shown above in Fig. 12;
Fig. 17 is a plan view of an alternate embodiment of a second end wall shown above in Fig. 12;
Fig. 18 is a simplified diagram of dual process chamber system employing the apparatus shown above in Figs. 1 and 10 in accordance with the present invention; and
Fig. 19 is a simplified block diagram showing hierarchical control structure of the system control software in accordance with the present invention.

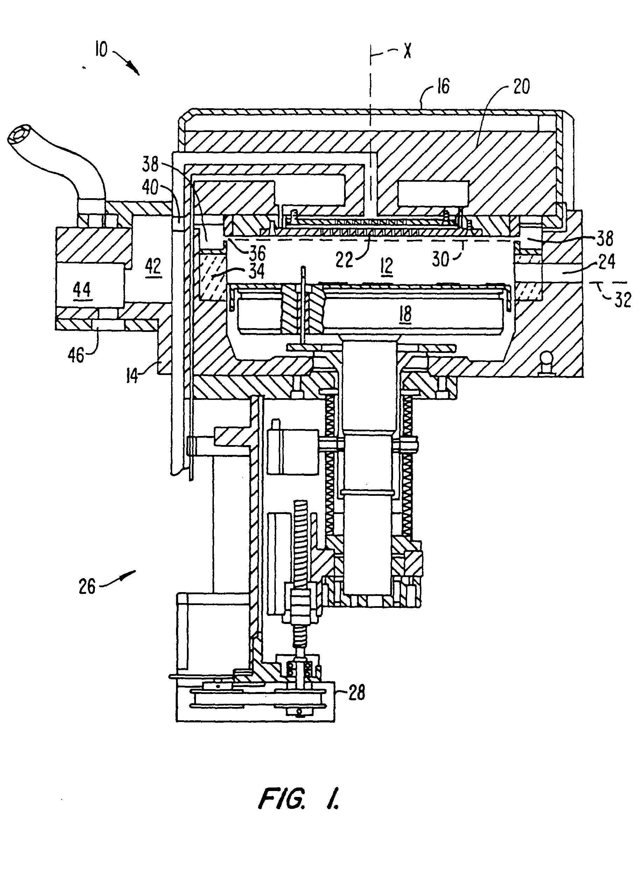

Referring to Fig. 1, a chemical vapor deposition (CVD) substrate processing apparatus 10 that may be employed in accordance with the present invention includes a process chamber 12 having a wall 14 and a lid assembly 16. Disposed within the process chamber 12 is a pedestal 18 that has a flat, or slightly convex upper surface, facing the lid assembly 16. Although the upper surface of the pedestal may be formed from any suitable material, dependent upon the process chemistry, it is preferred that the surface be formed from ceramic material, such as aluminum nitride. Also included in apparatus 10 is a fluid distribution assembly having a fluid distribution manifold 20 and a showerhead 22. The fluid distribution manifold 20 is positioned proximate to the lid assembly 16 and is in fluid communication with the process chamber 12. The showerhead 22 is disposed between the process chamber 12 and the fluid distribution manifold 20. Disposed in the wall 14, spaced-apart from the showerhead 22, is an opening 24 to facilitate insertion and removal of a substrate (not shown). The pedestal 18 is operably coupled to a lift mechanism 26 that includes a motor 28 to enable the pedestal 18 to move. Specifically, the pedestal 18 is configured to move between a processing position 30, disposed in a reaction region of the chamber 12 that is located proximate to the showerhead 22, and a wafer-loading position 32, located proximate to the opening 24. Positioning information for the various components in the process chamber, as well as the substrates (not shown), is obtained by a centerboard (not shown) that includes position detection sensors.

Disposed within the process chamber 12 is a dielectric liner 34 that extends from the wafer-loading position 32 toward the lid assembly 16 terminating proximate to the processing position 30, spaced-apart from the lid assembly 16 and defining an orifice 36 therebetween. The orifice 36 surrounds the reaction region. An exhaust plenum 38 is in fluid communication with the orifice 36. The process chamber 12 typically has a cylindrical shape, i.e., the orifice 36 and the plenum 38 both are radially symmetric with respect to axis X, that facilitates a uniform flow of process fluids over the surface 18a. To facilitate exhaust of process fluids from the process chamber 12, the exhaust plenum 38 extends outwardly away from the process chamber 12 forming a lateral extension portion 40 that is optically coupled to a viewing port (not shown). The lateral extension portion 40 is in fluid communication with a downwardly extending fluid passage 42 that terminates in a vacuum shut-off valve 44. The vacuum shut-off valve 44 controls fluid flow from the fluid passage 42 into an exhaust outlet 46 and is usually integrated with the wall 14. Typically an external vacuum system (not shown) is in fluid communication with the exhaust outlet 46 through a foreline (also not shown).

Typically, any or all of the various components in the process chamber 12 are made out of material such as aluminum, anodized aluminum, or ceramic. An example of such CVD apparatus is described in commonly assigned U.S. Patent 5,558,717, entitled "CVD Processing Chamber," issued to Zhao et al., which is incorporated by reference in its entirety.

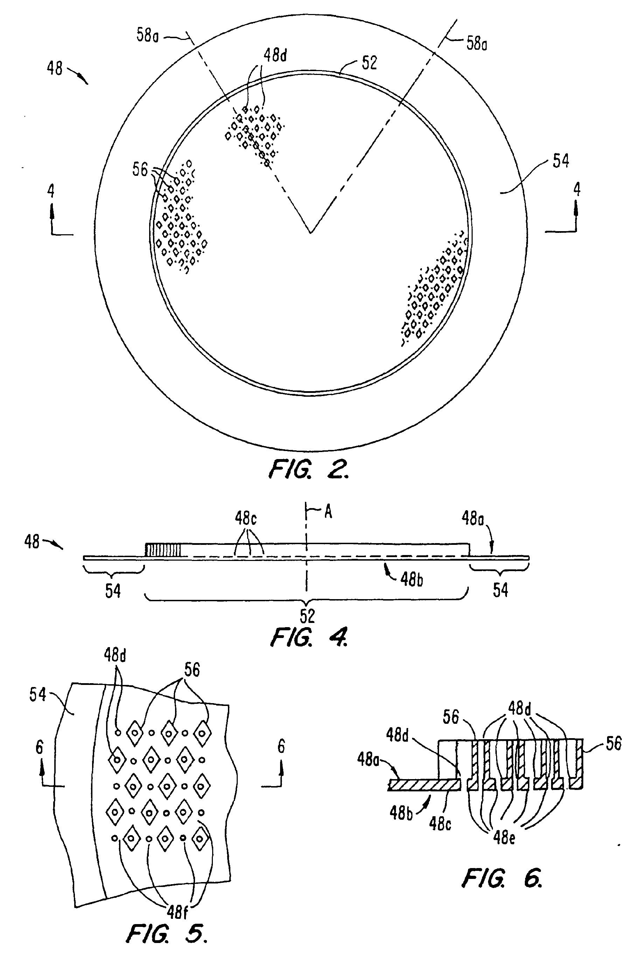

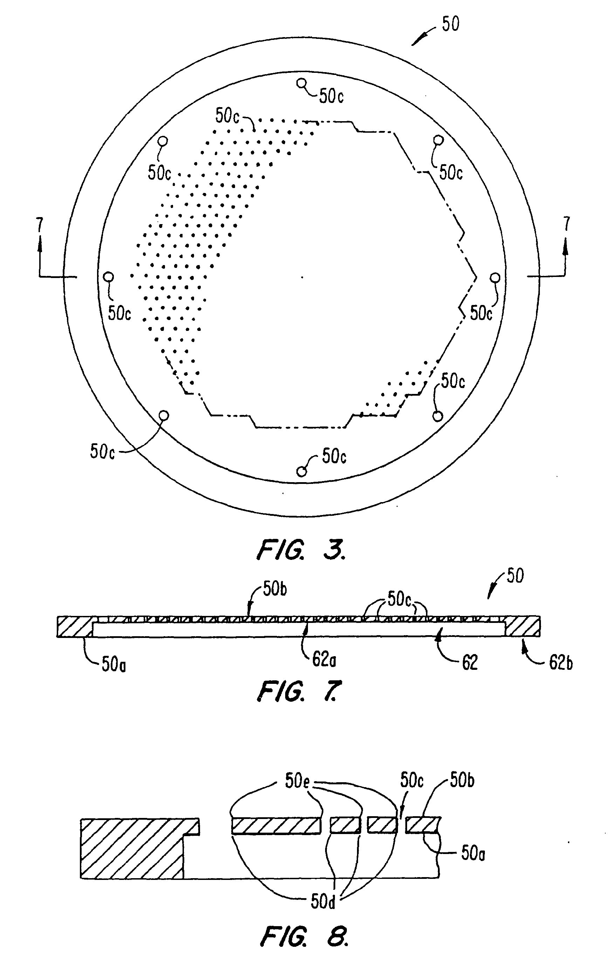

Referring to Figs. 2-8, showerhead 22 includes first and second fluid distribution plates 48 and 50. Each of the first and second fluid distribution plates 48 and 50 includes opposed major surfaces 48a, 48b, 50a and 50b, respectively. Also included in each of the first and second fluid distribution plates 48 and 50 are a plurality of throughways 48c and 50c, respectively, such that each extends between the opposed major surfaces. As shown, a plurality of apertures 48d is disposed in surface 48a, the apertures having a center-to-center spacing of approximately 6.35 mm. A plurality of apertures 48e is disposed in surface 48b, the apertures having a center-to-center spacing equivalent to the apertures 48a. Each of the through-ways 48c extends between one of the plurality of apertures 48d and one of the plurality of apertures 48e. In a similar manner, the throughways 50c extend through the opposed major surfaces 50a and 50b. Specifically, a plurality of apertures 50d is disposed in surface 50a, and a plurality of apertures 50e is disposed in surface 50b. Each of the throughways 50c extends between one of the plurality of apertures 50d and one of the plurality of apertures 50e. The aforementioned throughways and apertures may be any desired width, dependent upon the application.

With reference to Figs. 2, 4, 5 and 6 the first fluid distribution plate 48 is typically radially symmetric with approximately 700 throughways 48c disposed therein in a radially symmetric region 52 leaving an annular flange 54 surrounding the region 52. The flange 54 has a thickness, measured between opposed major surface 48a and 48b of approximately 2.55 mm and a width, measured transversely to the thickness, of approximately 2.54 cm. A subset of the plurality of throughways 48c is associated with a plurality of spaced-apart channel walls 56. Each of the plurality of spaced-apart channel walls 56 extends from major surface 48a, away from major surface 48b, enclosing a region 48f. Disposed within the region 48f is one of the plurality of apertures 48d. Regions of the major surface 48a disposed between adjacent channel walls 56 define a channel region 58, with a subset of the channel regions 58 having a throughway 48c placing the opposed major surfaces 48a and 48b in fluid communication. The width of the channel regions 58 is approximately 3.173 mm and the depth, measured from the surface 48a to the apex of the channel walls 56, is approximately 9.525 mm. The throughways 48c associated with the plurality of channel regions 58 are arranged in a plurality of collinear rows 58a, with each row 58a being positioned to form an oblique angle with respect to a horizontal, "h". Preferably, each row 58a forms a 60° angle with respect to the horizontal, "h". Disposed between the flange 54 and the region 52 is an annular protrusion 60. Typically, the annular protrusion 60 extends from the surface 48a, away from the surface 48b, coextensive with the plurality of channel walls 56. The annular protrusion 60 has a thickness, measured from the surface 48b, of approximately 1.21 cm.

Referring to Figs. 3, 7 and 8 the surface 50a of the second fluid distribution plate 50 includes a recess 62 bifurcating the surface 50a into a recessed surface 62a and a bulwark surface 62b surrounding the recess 62. Typically, the recess 62 has a circular shape, providing the bulwark surface 62b with an annular shape. The plurality of throughways 50c of the second fluid distribution plate 50 are all in fluid communication with the recess 62.

Referring to Figs. 2, 3 and 9 a first fluid distribution plate 48 is superimposed over the second fluid distribution plate 50 to keep the process fluids separate until the fluids reach the process region in the process chamber 12. To that end, the throughways 50c are arranged so that a subset 64 are in fluid communication with the regions 48f (see Fig. 5), with the remaining throughways 50c, defining a subset 66, being in fluid communication with the channel regions 58. Specifically, each of the throughways 50c of the subset 64 is uniquely associated with one of the regions 48f and, therefore, the throughways 48c present therein, with the remaining throughways 50c of the subset 64 being associated with a different region 48f.

Although any known manner may be employed to attach the first and second fluid distribution plates so that the interface formed therebetween forms a fluid-tight seal, such as shown in U.S. Patent No. 5,595,606, it is preferred that the first and second fluid distribution plates 48 and 50 are fused to one another, forming a unitary showerhead. Thus, surfaces 48a and 58a of plates 48 and 50 have a flatness of 1 to 3 mm to facilitate a fluid-tight interface between the first and second fluid distribution plates 48 and 50 without the use of O-rings. The fluid distribution plates 48 and 50 are generally fabricated from a metal such as aluminum or nickel.

Fusing of the first and second fluid distribution plates 48 and 50 is achieved by coating the surfaces 48a and 50a with silicon-rich aluminum and heating them while the fluid distribution plates 48 and 50 are clamped together. Specifically, the flange 54 is fused to the bulwark surface 62b, and the apex of each of the channel walls 56 is fused to the recessed surface 62a. In this fashion, the regions 48f are isolated from the channel regions 58, and a circumferential plenum 68 is defined between the surface 48a associated with the annular flange 54 and the recessed surface 62a facing the annular flange 54. The throughways of the subset 66 are in fluid communication with the circumferential plenum 68. Once the first and second fluid distribution plates 48 and 50 have been fused, a plurality of mounting bores 70 are formed to facilitate affixing the fluid distribution manifold 20 to the showerhead 22 via a plurality of bolts (not shown). Were the showerhead 22 fabricated of a material that reacts with the process fluids, a protective material such as nickel plated to a depth of 0.2 to 0.4 mils might be employed to avoid corrosion.

Referring to Figs. 2, 3 and 10, the gas distribution manifold 20 has two conduits 72 and 74. The fluid distribution manifold 20 includes a central recess that defines a fluid distribution gap 76 that faces the second fluid distribution plate 50. The fluid distribution gap 76 is in fluid communication with the subset 64 of throughways 50c that are aligned with the through-ways 48c disposed in the region 52. The conduit 74 is in fluid communication with the circumferential plenum 68. However, the plenum 68 is isolated from the gap 76. In this manner, the conduits 72 and 74 are in fluid communication with the subsets 64 and 66, respectively, of through-ways 58c.

Also in fluid communication with the conduit 72 is a first source of process fluids 78, and a second source of process fluids 80 is in fluid communication with conduit 74. During operation, process fluids are transported from the first and second sources of process 78 and 80 into conduits 72 and 74, respectively, of the fluid distribution manifold 20. Upon exiting the conduit 72, the first process fluid enters the fluid distribution gap 76, entering through-ways 50c associated with the subset 64 and into the process region, thereby dividing into a plurality of flows. The second process fluid exiting conduit 74 enters the through-ways 58c of the second subset 66 and into plenum 68, thereby surrounding the plurality of flows. The second process fluid entering the plenum 68 moves through the channel regions 58 into the through-ways 48c associated therewith, dividing into a plurality of tributaries. After flowing through the throughways 48c associated with the channel regions 58, the second process fluid enters the process region. With this arrangement, the first and second process fluids do not mix until after entering the process chamber 12. More specifically, the first and second process fluids maintain separation until after reaching the process regions. In a suitable deposition process, a substantial portion of the first and second process fluids mix after reaching the process region and deposit onto a substrate (not shown) resting on the pedestal 18.

Process fluids that do not result in deposition on the aforementioned substrate are evacuated from the process chamber 12 by a vacuum pump (not shown). Specifically, the gases are exhausted through the orifice 36 and out the exhaust outlet 46 via the exhaust passage 42.

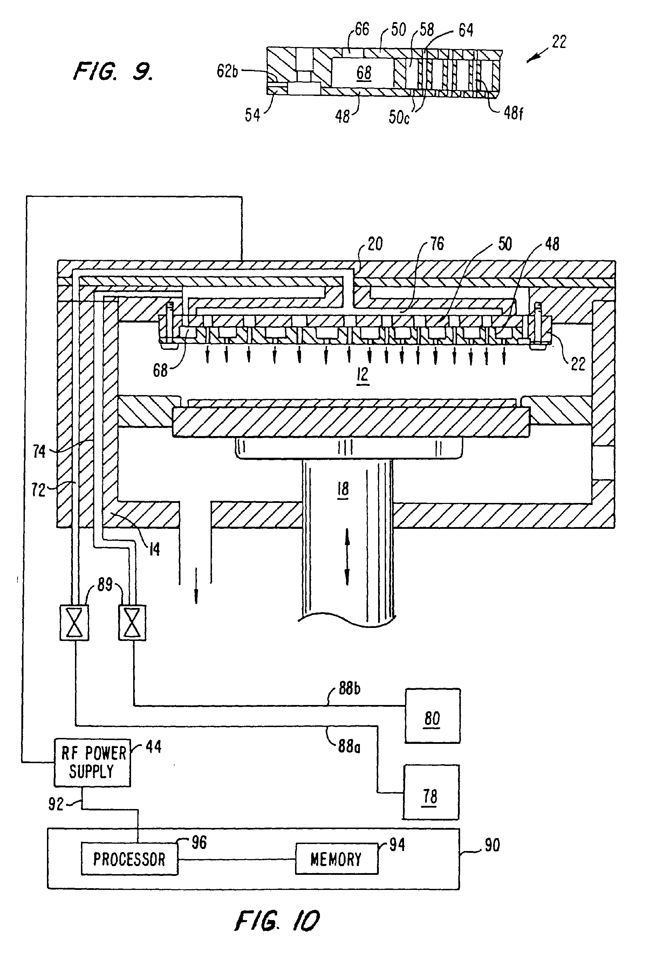

Referring to Fig. 10, in one embodiment of the present invention the process fluids may include differing gases that are supplied through gas supply lines 88a and 88b that are combined after entering the process chamber 12 as discussed above. It is also possible to combine one or more of the gases in a mixing manifold (not shown) before they enter the fluid distribution manifold 20, thereby providing one or more differing mixtures of gases that is mixed again with a differing gas, or mixture of gases after reaching the process region, as discussed above. As shown there are two gas supply lines 88a and 88b in a specific embodiment to deposit tungsten silicide WSiₓ. A first line 88a may supply a silicon-containing gas (e.g., dichlorosilane (SiH₂Cl₂) referred to as "DCS" from a DCS source from fluid source 78) into conduit 72, while a second line 88b supplies a tungsten-containing gas (e.g., tungsten hexafluoride (WF₆) from a WF₆ source from gas source 80) into conduit 74. For each line 88a and 88b, a carrier gas (e.g., argon from argon sources in gas sources 78 and 80) can be supplied with the process to stabilize gas flows as appropriate and to even the gas flow between the two lines. As discussed above the gases (DCS and WF₆) are not mixed until reaching the process regions. It is believed that the present combination of fluid distribution manifold 20 and showerhead 22 provides a uniform gas distribution into the chamber, resulting in uniform deposition of a WSix film. A third supply line (not shown) may introduce an inert purge gas (not shown) from the bottom of the process chamber 12 to keep deposition gases away from the area of the chamber the pedestal 18.

Generally, the supply line for each process fluid includes (i) several safety shut-off valves 89 that can be used to automatically or manually shut off the flow of process gas into the chamber, and (ii) mass flow controllers (Macs) (not shown) that measure the flow of gas through the supply line. When toxic gases are used in the process, the several safety shut-off valves are positioned on each gas supply line in conventional configurations.

The deposition process performed in process chamber 12 may be a thermal process, a plasma-enhanced process or a remote plasma process. In a thermal process, the process fluid mixture, typically a gas, thermally reacts to deposit the desired film on the surface of the semiconductor wafer supported on pedestal 18, which is resistively heated to provide the thermal energy needed for the reaction. To that end, the pedestal 18 typically includes a heating element, such as an embedded single-loop of conductive wire configured to make two full turns in the form of parallel concentric circles. An outer portion of the heater element runs adjacent to a perimeter of the support platter, while an inner portion runs on the path of a concentric circle having a smaller radius. The wiring to the heater element passes through the stem of pedestal 18. Were the pedestal 18 formed with the aforementioned conductive wire, it would typically be fabricated from aluminum, ceramic, or some combination thereof. A hot liquid is circulated through the walls 14 of process chamber 12 to maintain the walls at an elevated temperature. Fluids used to heat the chamber walls 14 include the typical fluid types, i.e., water-based ethylene glycol or oil-based thermal transfer fluids. This heating beneficially reduces or eliminates condensation of undesirable reactant products and improves the elimination of volatile products of the process gases and contaminants that might otherwise condense on the walls of cool vacuum passages and migrate back into the process chamber during periods of no gas flow.

In a plasma-enhanced process, an RF power supply 44 applies electrical power between the shower head 22 and the pedestal 18 to excite the process fluid mixture, typically a mixture of gases, to form a plasma in the process region. The plasma heats the entire process chamber 12, including the chamber walls 14, surrounding the exhaust passageway 23 and the shut-off valve 24. Constituents of the plasma react to deposit a desired layer on the surface of the semiconductor wafer (not shown) supported on pedestal 18. RF power supply 44 can be a mixed frequency RF power supply that typically supplies power at a high RF frequency (RF1) of 13.56 megahertz (MHz) and at a low RF frequency (RF2) of 360 kilohertz (kHz) to enhance the decomposition of reactive species introduced into the process chamber 12. Of course, RF power supply 44 can supply either single- or mixed-frequency RF power (or other desired variations) to fluid distribution manifold 20 to enhance the decomposition of reactive species introduced into the process chamber 12.

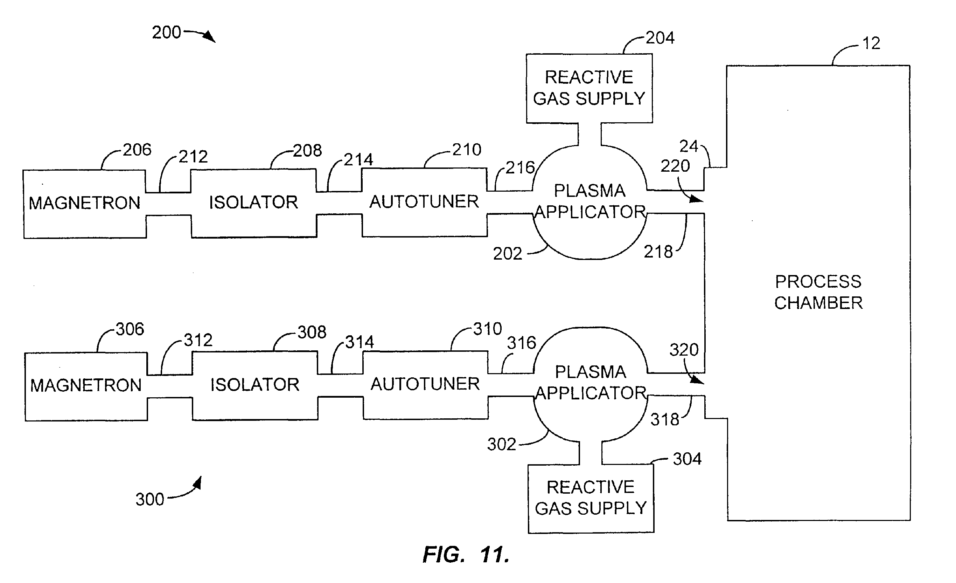

Referring to Fig. 11, the preferred embodiment, however, deposits a layer upon a substrate in the process chamber 12 employing a remote plasma process. More particularly, the preferred embodiment of the present invention includes a first source of a plasma 200, and a second source of a plasma 300. As shown, the first plasma source 200 is in fluid communication with the process chamber 12 via conduit 220, and the second plasma source 300 is in fluid communication with the process chamber via conduit 320. In this manner, the process fluid entering the process chamber 12 includes a plurality of reactive radicals comprising ionized atoms or molecules dissociated by a plasma.

The first source of plasma 200 includes a plasma applicator 202 in fluid communication with both a supply 204 of a reactive gas, such as titanium chloride, and the process chamber 12. A microwave generator, such as a magnetron 206, is in electrical communication with the plasma applicator 202 via an isolator 208 and an autotuner 210. Specifically, a first waveguide 212 is coupled between the magnetron 206 and the isolator 208; a second waveguide 214 is coupled between the autotuner 210 and the isolator 208; and a third waveguide 216 is coupled between the autotuner 210 and the applicator 202. The microwave energy generated by the magnetron travel toward the applicator 202 by traversing waveguides 212, 214 and 216. The autotuner 210 reduces the amount of microwave energy reflected into the magnetron 206. The autotuner 210 minimizes the microwave energy reflected by the applicator 202 back into the remaining components of the plasma source 200.

A reactive gas from supply 204 is flowed, under vacuum from the substrate process chamber's pumping and exhaust system (not shown), into the plasma applicator 202 where microwave energy transmitted from the magnetron 206 forms standing waves. The standing waves in applicator 202 ignite and maintain a plasma from the reactive gas, and a flow of reactive radicals, also under vacuum, is discharged from applicator 202 through output waveguide 218 and toward the process chamber 12 via conduit 74 in fluid distribution manifold.

The second source of plasma 300 includes the components 306, 308, 310, 312, 314 and 316 which are identical to components 206, 208, 210, 212, 214 and 216 mentioned above with respect to the first source of plasma 200. However, the supply 304 of reactive gas is typically different than the supply 204 of reactive gas. In the present example the supply 304 of reactive gas is typically ammonia. The reactive radicals produced by the second source of a plasma 300 flow into the fluid distribution manifold via conduit 320. In this manner, separation between the two flows of reactive radicals is maintained until reaching the process region, for the reasons discussed above.

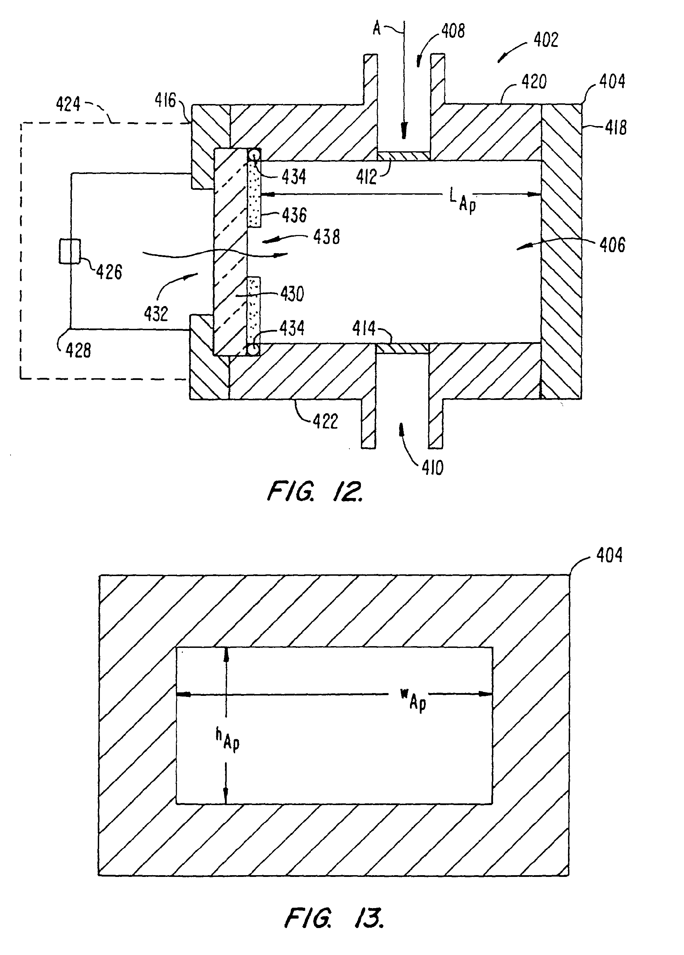

Referring to Fig. 12, although any plasma applicator may be used for applicator 202 or 302, in one embodiment a plasma applicator 402 includes body 404 defining a volume 406 of desired shape. A fluid inlet 408 is disposed opposite to a fluid outlet 410 so that a fluorine-containing reactive gas may pass therebetween. Positioned at the juncture between the volume 406 and the fluid inlet 408 is a first microwave arrestor 412. Similarly, at the juncture between the fluid outlet and the volume 406 is a second microwave arrestor 414. The arrestors 412 and 414 prevent egress of the microwave plasma from volume 406 and are preferably comprised of grids, or metal plates having a plurality of throughways. For example, arrestors 412 and 414 may be formed from aluminum plates having a thickness ranging from about 1.27-6.35 mm, preferably about 3.55 mm, with small holes therethrough, each of which has a diameter of about 3.17 mm or less. The center-to-center hole separation ranges from about 2.54-10.20 mm, preferably about 7.87 mm. This design prevents microwave energy having a frequency of about 2.45 GHz from escaping the applicator 402, thereby preventing a plasma present therein from traversing through either fluid inlet 408 or fluid outlet 410. The aforementioned holes allow the reactive gases to enter, and radicals to exit, the applicator 402. The plasma applicator 402 also includes first and second spaced-apart end walls 416 and 418 with two spaced-apart side walls 420 and 422 extending between the first and second end walls 416 and 418. The fluid inlet is formed into the first side wall 420, and the fluid outlet 410 is formed into the second side wall 422. Typically, the walls 416, 418, 420 and 422 are made from aluminum, but other materials may be employed, including copper, stainless steel and the like.

A microwave generator, such as a magnetron 424 is in electrical communication with the first end wall 416 via an antenna 426 coupled to a waveguide system 428 to transmit microwave energy into the volume 406. The magnetron is typically a CW microwave source providing microwaves at about 2.45 GHz and between about 75 Watts (W) to about 1 kW of microwave power. The antenna may be any known antenna in the art suitable for microwave transmission, including a stub antenna, a slot antenna or the like. The antenna is positioned to optimize the transfer of microwave energy into the waveguide 428 and is typically about one quarter-wavelength away from one end of waveguide system 428.

The waveguide system 428 may include more than one waveguide sections and tuning elements, which are well known to one of ordinary skill in the art. Typically, the waveguide system 428 may be a section of rectangular cross-sectional waveguide, but waveguides having other cross-sectional dimensions (e.g., circular) may be used in other embodiments. The waveguide system 428 may have any desired length with a waveguide width of about 86.30 mm and a waveguide height of about 43.10 mm. Part of waveguide system 428 is adjacent to microwave source 424 at one end and adjacent to plasma applicator 402 at its other end. Waveguide system 428 may also optionally include other optimizing features, such as directional couplers or a phase detector to monitor reflected power and/or an isolator with a load to absorb any reflected microwave power that could otherwise damage the magnetron.

To facilitate transfer of microwave energy from the waveguide system 428 to the volume 406, the first end wall 416 may include a microwave-transparent plate 430 and an aperture 432 extending between the waveguide 428 and the plate 430. The microwave-transparent plate 430 may be formed from any material that is transparent to microwaves, such as alumina (Al₂O₃) in either ceramic or sapphire form, depending upon the application. Al₂O₃ in sapphire form is most preferred in some specific embodiments. In specific embodiments, plate 430 has dimensions greater than the transverse dimensions of the volume 406, and the dimensions of the aperture 432 substantially correspond to the cross-sectional dimensions of waveguide system 428. The thickness of microwave-transparent plate 430 is chosen in order to optimize the operational life while maximizing microwave power transfer. Typically, the thickness of microwave-transparent plate 430 ranges from about 6.35-19.00 mm, with about 10.20 mm being the preferred thickness.

Fluid-tight integrity of the volume 406 should be maintained. To that end, the components of plasma applicator 402 may be coupled together by any method known in the art to provide fluid-tight seals. For example, brazing, welding, or fastening mechanisms such as screws may be employed to connect the first and second end walls 416 and 418 to side walls 420 and 422. Typically, the second end wall 418 is removably attached to side walls 420 and 422 to facilitate cleaning of the volume 406 by physically wiping the volume 406 with a special cloth and cleaning liquids. To that end, bolts (not shown) may be employed to couple the second end wall 418 to the side walls 420 and 422. Fluid-tight integrity may be maintained by disposing sealing members therebetween, such as sealing member 434, which is disposed between the microwave-transparent plate 430 and first and second side walls 420 and 422. Any type of sealing member may be employed, including a buna-rubber O-ring, and/or gaskets made from metal, such as aluminum, or from Teflon™ or another appropriate material impervious to microwaves.

Referring to Figs. 12 and 13, the volume is shown as having a rectangular cross-section in two orthogonal planes, both of which extend parallel to flow path A. The dimensions of the walls 416, 418, 420 and 422 are selected so that the volume has dimensions, e.g., length (l_{AP}), width (w_{AP}) and height (h_{AP}), necessary to achieve the desired resonance mode of the microwave energy. Typically the dimensions of the volume 406 are established to obtain one of the TE10n resonance modes, where n is an integer. In addition, the dimensions of the volume 406 may be established to minimize the microwave energy reflected by the plasma. To adjust the dimensions of the volume 406, a metal plate 436 may be disposed adjacent to the microwave-transparent plate 430 so as to face the volume 406. The metal plate 436 may be a metal foil or a sputtered or otherwise deposited metal layer on microwave-transparent plate 430. The metal plate may include a centrally located aperture 438 to guide microwaves into the volume 406.

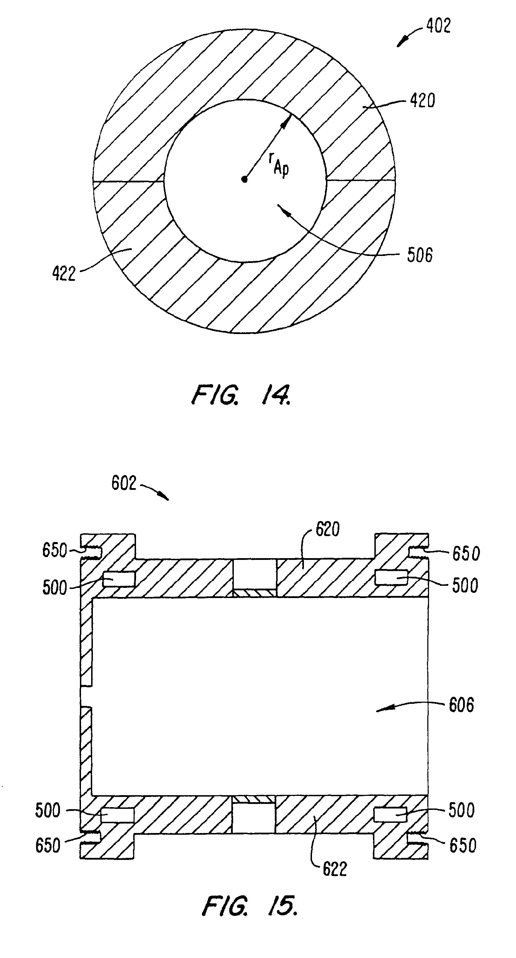

Referring to Figs. 12 and 14, the side-walls 420 and 422 may define a cylindrical volume 506, having an applicator length (l_{AP}) and a radius (r_{AP}), with l_{AP} and r_{AP} chosen to excite one of the TE1 In resonance modes (where n is an integer). The dimensions of l_{AP} and r_{AP} may range from about 50.80-102.00 mm, and about 38.10-127.00 mm, respectively, depending upon the resonance mode desired. For example, to obtain the TE111 resonance mode, l_{AP} and r_{AP} are established to be approximately 93.10 mm and 50.80 mm, respectively. Preferably, the volume has dimensions to excite the TE111 resonance mode of the microwaves.

Referring to Fig. 15, the plasma applicator 602 is shown as having passages 500 which are disposed at opposite ends of the volume 606 and are complementary to the shape of the first and second sidewalls 620 and 622. In an exemplary embodiment, the first and second side walls 620 and 622 define a cylindrical volume 606, and the passages 500 have an annular shape. The thickness of the first and second sidewalls 620 and 622 range from about 1.25 mm to 6.35 mm, preferably about 3.55 mm, separating passages 500 from the volume 606. The passages 500 are built into the sidewalls 620 and 622 to provide a path through which a flow of coolant may be placed in thermal communication with the volume 606. The cross-sectional dimensions of each passage 500 range from about 2.54 mm to 25.40 mm in length, with 13.50mm being preferred, and from about 2.54mm to 25.90 mm in height, with about 10.20 mm being preferred. To that end, the total thickness of each of the applicator body 602 ranges from about 5.08 mm-76.10 mm, preferably about 25.40 mm, so that applicator body 602 meets strength requirements and heat transfer passages 500 are accommodated.

Cooling the volume 606 in this manner facilitates transport of radicals to the downstream mixing manifold (not shown). For example, when using a fluorine-containing reactive gas such as NF₃ to form the plasma in applicator, the reactive gas reacts with materials from which it is composed, typically aluminum. This results in the formation of aluminum fluoride (AIF) in the volume 606. Aluminum fluoride forms at rates on the order of ms per minute in remote plasma systems reaching temperatures of about 400°C. Flowing various coolants, such as water, water-based ethylene glycol, or oil-based thermal transfer fluids through passages 500, allows the volume 606 temperature to be maintained at a predetermined temperature ranging from about 0-100°C. At these temperatures, it is believed that A1F forms at significantly slower rates on the order of ms per year. In one experiment, the use of water, for example, at about 20-25°C, circulating through heat exchange passages 500 at a rate of at least about 2 liters/minute, preferably about 3 liters/minute, can maintain the volume 606 at temperatures as low as room temperature (approximately 25°C). In another experiment, water at temperatures lower than about 20°C, flowing at about 3 liters/minute, maintained the volume 606 at temperatures lower than approximately 25°C. The cooling properties provided by the passages 500 coolant flow therethrough also result in lowering the temperature of the microwave-transparent plate (not shown) by conduction with the side walls 620 and 622. This reduces the probability of cracking the plate 436 due to thermal shock.

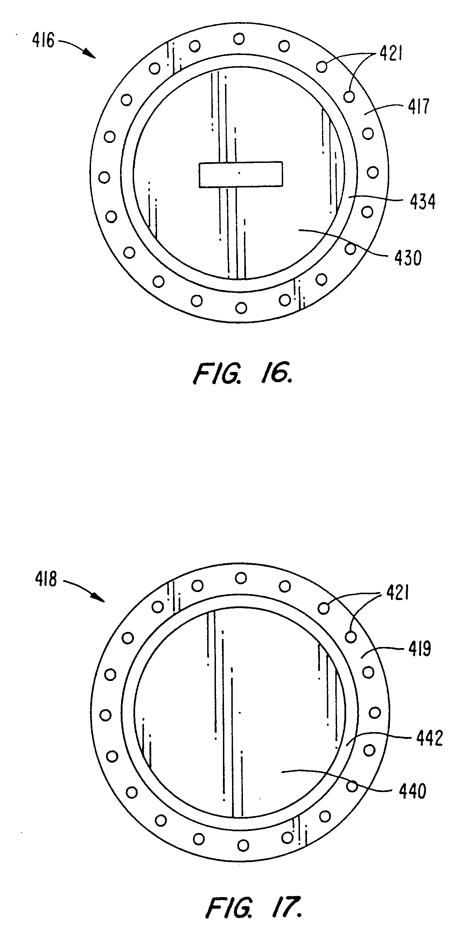

Referring to Figs. 14, 15, 16 and 17, a plurality of equally spaced threaded bores 650 are disposed about the circumference of the opposed ends of the plasma applicator 602 to facilitate removably attaching the first and second end walls 416 and 422. Specifically, the first end wall 416 is shown as being circular with the an outer region 417 having a plurality of blind holes 421 which are adapted to align with the plurality of threaded bores 650, when placed in a final seating position. Similarly, the second end wall 418 also includes an outer region 419 having a plurality of blind holes 421 which align with the plurality of thread bores 650. In this fashion, a plurality of screws (not shown) may be employed to rigidly attach the first and second end walls 416 and 418 to the side walls 420 and 422.

To facilitate formation of a fluid-tight seal, an annular sealing member 434 is disposed about the circular microwave transparent plate 430 in the first end wall 416. The sealing member 434 has a radius slightly less than the radius of the microwave transparent-plate 430, preferably about 57.10 mm. The radius of the microwave transparent-plate 430 ranges from about 25.40-127.00 mm, with about 63.50 mm being preferred. Having a thickness ranging from about 0.03-6.35 mm, preferably about 3.17 mm, metal sheet 436 (Fig. 12) has a thickness optimized to provide good thermal contact to transfer heat from the microwave-transparent plate 430. This reduces thermal shock and, therefore, arcing. The aperture 438 (Fig. 12) has a rectangular shape with a width (w_{A}) of about 61.20 mm and a height (h_{A}) of about 9.64 mm. However, aperture 438 may have any shape and dimensions desired, depending upon the application.

Similar to the first end wall 416, the second end wall 418 has a circular shape with an annular groove 440 formed therein. The annular groove 440 surrounds a portion of the second end wall having a cross section matching a cross section of the volume 606. A sealing member, such as an O-ring 442 is disposed in the groove 440 to facilitate formation of a fluid-tight seal between the first and second side walls 420 and 422 and the second end wall 418.

Referring again to Fig. 11, although remote plasma sources 200 and 300 have each been described as using a magnetron 206 and 306, respectively, as the source for microwave energy, any type of microwave generators may be employed. For example, an inexpensive pulsed, low wattage power supply to generate between about 1-1.5 kW microwave power from the magnetron, or a high wattage, continuous wave (CW) power supply to generate typically up to about 2.5-6 kW microwave power from the magnetron. In some preferred embodiments, magnetron 305 may be the type of magnetron employed in some microwave ovens and may be powered by a low cost, low wattage, pulsed 60 Hertz (Hz) half-rectified power source (which contains large ripples) to provide microwaves having a frequency of about 2.45 Gigahertz (GHz). Such pulsed, low wattage microwave generators can be at least two orders of magnitude lower in price than a high power CW microwave generator or an RF generator.

The waveguides 212, 214, 216, 312, 314 and 316 may be any type known in the art, and may be made of aluminum, copper, stainless steel, and the like. The dimensions of the waveguides 212, 214, 216, 312, 314 and 316 are those needed to merely transmit microwave energy to plasma applicators 202 and 302 without selectively guiding particular modes, according to the specific embodiment.

The RF isolator is typically made of a material that provides RF isolation, such as polytetrafluoroethylene (PTFE), and which is resistant to etching or deposition by radicals (such as fluorine radicals when forming the plasma using a fluorine-containing gas like NF₃). In addition to PTFE (commercially available, for example, as Teflon™ PTFE), any fluorinated material including fluorinated polymers such as PFA (which is a polymer combining the carbon-fluorine backbone of polytetrafluoroethylene resins with a perfluoro-alkoxy side chain), fluorinated ethylene-propylene (TFE), or the like, also may be used. Of course, other materials may be used that are resistant to the particular reactive chemistry used.

In the present invention, reactive gases that are supplied to applicator designs discussed above with respect to Figs. 12-17 can be ignited using fairly low microwave power to form a plasma sustained by the standing waves formed therein. For example, as little as about 250 W of microwave power may be provided to strike a plasma, in contrast to conventional microwave plasma systems where a UV lamp or high microwave power levels on the order of 3 kW are required to strike plasma. Therefore, by employing the applicators discussed above, a plasma may be formed without the use of a plasma-enhancing gas like argon and without a UV lamp, thereby decreasing the unit cost of the applicator. Advantageously, microwaves resonating in the plasma applicator are able to energize reactive gases in the entire volume of the plasma applicator for efficient microwave energy usage and effective plasma ignition, compared to conventional remote microwave plasma systems where a small volume in a plasma applicator tube (disposed through a small portion of waveguide) contains the plasma.

Referring to both Figs. 1 and 10, control of the operations of the process chamber 12, such as control of the motor 28, valves or flow controllers 89 connected to the supply lines 88a and 88b, fluid delivery system, throttle valve, RF power supply 44, and chamber and substrate heating systems are all controlled by a system controller 90 over control lines 92, only some of which are shown. Controller 90 relies on feedback from optical sensors to determine the position of movable mechanical assemblies such as the throttle valve and pedestal which are moved by appropriate motors controlled by the system controller 90.

In a preferred embodiment, the system controller 90 includes a hard disk drive (memory 94), a floppy disk drive and a processor 96. The processor contains a single-board computer (SBC), analog and digital input/output boards, interface boards and stepper motor controller boards. Various parts of substrate processing apparatus 10 conform to the Versa Modular European (VME) standard which defines board, card cage, and connector dimensions and types. The VME standard also defines the bus structure as having a 16-bit data bus and a 24-bit address bus.

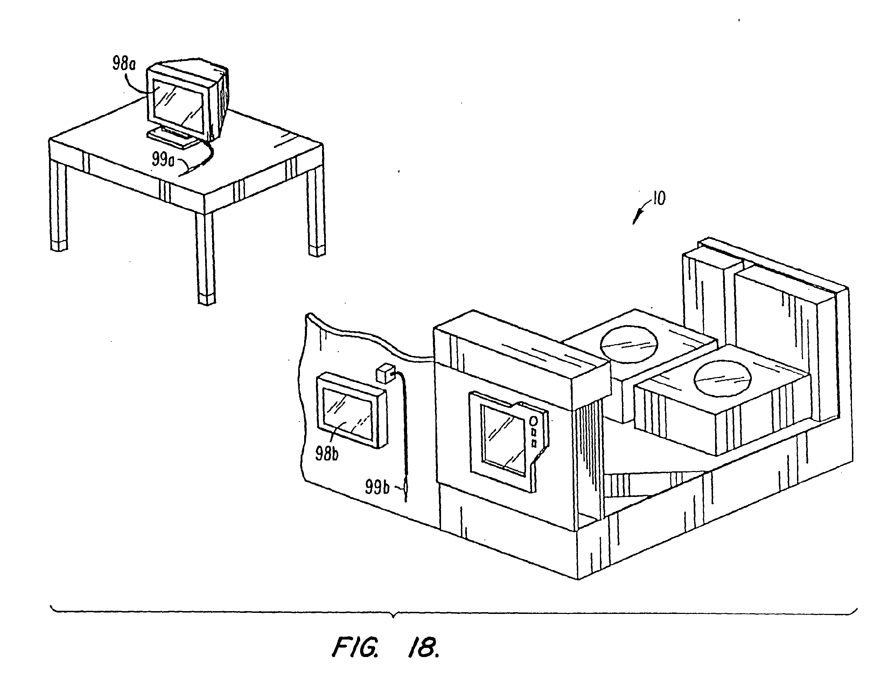

The system controller 90 operates on control software, which is a computer program stored in a computer-readable medium such as the memory 94. The computer program includes sets of instructions that dictate the timing, mixture of fluids, chamber pressure, chamber temperature, RF power levels, pedestal position, and other parameters of a particular process. The interface between a user and system controller 90 is via a CRT monitor 98a and light pen 99a, shown in Fig. 18, which is a simplified diagram of the system monitor and substrate processing apparatus 10 in a substrate processing system, which may include one or more chambers. In the preferred embodiment two monitors 98a and 98b are used, one mounted in the clean room wall for the operators and the other behind the wall for the service technicians. The monitors 98a and 98b simultaneously display the same information, but only one light pen 99a and 99b is enabled. A light sensor in the tip of the light pens 98a and 98b detects light emitted by CRT display. To select a particular screen or function, the operator touches a designated area of the display screen and pushes the button on the appropriate light pen 98a and 98b. The touched area changes its highlighted color, or a new menu or screen is displayed, confirming communication between the light pen and the display screen. Other devices, such as a keyboard, mouse, or other pointing or communication device, may be used instead of or in addition to the light pens 98a and 98b to allow the user to communicate with the system controller 90, shown in Fig. 10

The process for depositing the film can be implemented using a computer program product that is executed by the system controller 90. The computer program code can be written in any conventional computer readable programming language: for example, 68000 assembly language, C, C++, Pascal, Fortran or others. Suitable program code is entered into a single file, or multiple files, using a conventional text editor and stored or embodied in a computer-usable medium, such as a memory system of the computer. If the entered code text is in a high level language, the code is compiled, and the resultant compiler code is then linked with an object code of precompiled Windows™ library routines. To execute the linked, compiled object code, the system user invokes the object code causing the computer system to load the code in memory. The CPU then reads and executes the code to perform the tasks identified in the program.

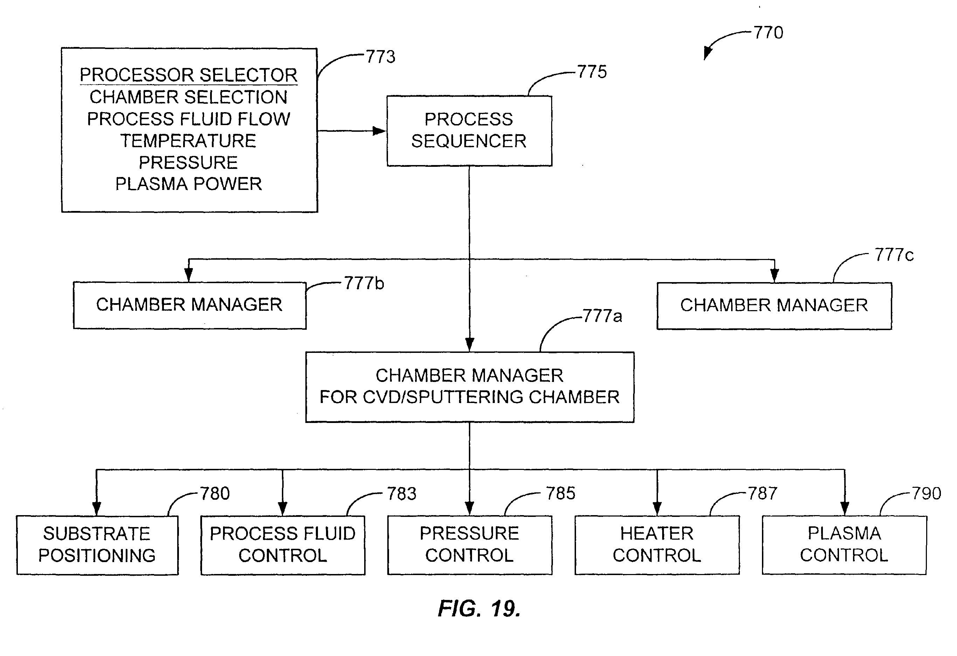

Fig. 19 is an illustrative block diagram of the hierarchical control structure of the system control software, computer program 770, according to a specific embodiment. Using the aforementioned light pen interface, a user enters a process set number and process chamber number into a process selector subroutine 773 in response to menus or screens displayed on the CRT monitor. The process sets are predetermined sets of process parameters necessary to carry out specified processes and are identified by predefined set numbers. The process selector subroutine 73 identifies (i) the desired process chamber and (ii) the desired set of process parameters needed to operate the process chamber for performing the desired process. The process parameters for performing a specific process relate to process conditions such as process fluid composition and flow rates, temperature, pressure, plasma conditions such as microwave power levels or RF power levels and the low-frequency RF frequency, cooling fluid pressure, and chamber wall temperature. These parameters are provided to the user in the form of a recipe and are entered using the light pen/CRT monitor interface.

The signals for monitoring the process are provided by the analog and digital input boards of the system controller, and the signals for controlling the process are output on the analog and digital output boards of CVD apparatus 10. A process sequencer subroutine 775 comprises program code for accepting the identified process chamber and set of process parameters from the process selector subroutine 773 and for controlling operation of the various process chambers. Multiple users can enter process set numbers and process chamber numbers, or a user can enter multiple process set numbers and process chamber numbers, so the sequencer subroutine 775 operates to schedule the selected processes in the desired sequence. Preferably, the sequencer subroutine 775 includes a program code to perform the steps of (i) monitoring the operation of the process chambers to determine if the chambers are being used, (ii) determining what processes are being carried out in the chambers being used, and (iii) executing the desired process based on availability of a process chamber and type of process to be carried out. Conventional methods of monitoring the process chambers can be used, such as polling. When scheduling which process is to be executed, sequencer subroutine 775 takes into consideration the present condition of the process chamber being used in comparison with the desired process conditions for a selected process, or the "age" of each particular user entered request, or any other relevant factor a system programmer desires to include for determining scheduling priorities.

Once the sequencer subroutine 775 determines which process chamber and process set combination is going to be executed next, the sequencer subroutine 775 initiates execution of the process set by passing the particular process set parameters to a chamber manager subroutine 777a-c, which controls multiple processing tasks in a process chamber 12 according to the process set determined by the sequencer subroutine 775. For example, the chamber manager subroutine 777a comprises program code for controlling sputtering and CVD process operations in the process chamber 12. The chamber manager subroutine 777 also controls execution of various chamber component subroutines that control operation of the chamber components necessary to carry out the selected process set. Examples of chamber component subroutines are substrate positioning subroutine 780, process fluid control subroutine 783, pressure control subroutine 785, heater control subroutine 787, and plasma control subroutine 790. Those having ordinary skill in the art will readily recognize that other chamber control subroutines can be included depending on what processes are to be performed in the process chamber 12. In operation, the chamber manager subroutine 777a selectively schedules or calls the process component subroutines in accordance with the particular process set being executed. The chamber manager subroutine 777a schedules the process component subroutines much like the sequencer subroutine 775 schedules which process chamber 12 and process set are to be executed next. Typically, the chamber manager subroutine 777a includes steps of monitoring the various chamber components, determining which components need to be operated based on the process parameters for the process set to be executed, and causing execution of a chamber component subroutine responsive to the monitoring and determining steps.

Referring to both Figs. 1 and 19, the substrate positioning subroutine 780 comprises program code for controlling chamber components that are used to load the substrate onto pedestal 18 and, optionally, to lift the substrate to a desired height in the process chamber 12 to control the spacing between the substrate and the showerhead 22. When a substrate not shown) is loaded into the process chamber 12, pedestal 18 is lowered to receive the substrate; thereafter, pedestal 18 is raised to the desired height in the chamber, to maintain the substrate at a first distance or spacing from the fluid distribution manifold during the CVD process. In operation, the substrate positioning subroutine 780 controls movement of pedestal 18 in response to process set parameters related to the support height that are transferred from the chamber manager subroutine 777a.

The process fluid control subroutine 783 has program code for controlling process fluid composition and flow rates. The process fluid control subroutine 783 controls the open/close position of the safety shut-off valves, and also ramps up/down the mass flow controllers to obtain the desired fluid flow rate. The process fluid control subroutine 783 is invoked by the chamber manager subroutine 777a, as are all chamber component subroutines, and receives from the chamber manager subroutine process parameters related to the desired fluid flow rates. Typically, the process fluid control subroutine 783 operates by opening the fluid supply lines and repeatedly (i) reading the necessary mass flow controllers, (ii) comparing the readings to the desired flow rates received from the chamber manager subroutine 777a, and (iii) adjusting the flow rates of the fluid supply lines as necessary. Furthermore, the process fluid control subroutine 783 includes steps for monitoring the fluid flow rates for unsafe rates and for activating the safety shut-off valves when an unsafe condition is detected.

In some processes, an inert fluid such as helium or argon gas is flowed into the process chamber 12 to stabilize the pressure in the chamber before reactive process fluids are introduced. For these processes, the process fluid control subroutine 783 is programmed to include steps for flowing the inert fluid into the process chamber 12 for an amount of time necessary to stabilize the pressure in the chamber, and then the steps described above would be carried out. Additionally, if a process fluid includes a gas to be vaporized from a liquid precursor, for example, tetraethylorthosilicate ("TEOS"), the process fluid control subroutine 783 is written to include steps for bubbling a delivery fluid, such as helium gas, through the liquid precursor in a bubbler assembly or introducing a carrier fluid, such as helium gas or nitrogen gas, to a liquid injection system. When a bubbler is used for this type of process, the process fluid control subroutine 783 regulates the flow of the delivery fluid, the pressure in the bubbler, and the bubbler temperature in order to obtain the desired process fluid flow rates. As discussed above, the desired process fluid flow rates are transferred to the process fluid control subroutine 783 as process parameters. Furthermore, the process fluid control subroutine 783 includes steps for obtaining the necessary delivery fluid flow rate, bubbler pressure, and bubbler temperature for the desired process fluid flow rate by accessing a stored table containing the necessary values for a given process fluid flow rate. Once the necessary values are obtained, the delivery fluid flow rate, bubbler pressure and bubbler temperature are monitored, compared to the necessary values and adjusted accordingly.

The pressure control subroutine 785 comprises program code for controlling the pressure in the process chamber 12 by regulating the size of the opening of the throttle valve in the exhaust system of the chamber. The size of the opening of the throttle valve is set to control the chamber pressure to the desired level in relation to the total process fluid flow, size of the process chamber, and pumping set-point pressure for the exhaust system. When the pressure control subroutine 785 is invoked, the target pressure level is received as a parameter from the chamber manager subroutine 777a. The pressure control subroutine 785 operates to measure the pressure in the chamber 12 by reading one or more conventional pressure manometers connected to the chamber, to compare the measured value(s) to the target pressure, to obtain PID (proportional, integral, and differential) values from a stored pressure table corresponding to the target pressure, and to adjust the throttle valve according to the PID values obtained from the pressure table. Alternatively, the pressure control subroutine 785 can be written to open or close the throttle valve to a particular opening size to regulate the process chamber 12 to the desired pressure.

The heater control subroutine 787 comprises program code for controlling the current to a heating unit that is used to heat the pedestal 18 if the same includes the conductive wire (not shown) embedded therein as discussed above. The heater control subroutine 787 is also invoked by the chamber manager subroutine 777a and receives a target, or set-point, temperature parameter. The heater control subroutine 787 measures the temperature by measuring voltage output of the aforementioned embedded wire, comparing the measured temperature to the set-point temperature, and increasing or decreasing current applied to the heating unit to obtain the set-point temperature. The temperature is obtained from the measured voltage by looking up the corresponding temperature in a stored conversion table or by calculating the temperature using a fourth-order polynomial. When an embedded loop is used to heat pedestal 18, the heater control subroutine 787 gradually controls a ramp up/down of current applied to the loop. Additionally, a built-in fail-safe mode can be included to detect process safety compliance and can shut down operation of the heating unit if the process chamber 12 is not properly set up.

The plasma control subroutine 790 comprises program code for setting the low- and high-frequency RF power levels applied to the process electrodes in the process chamber 12, and for setting the low-frequency RF frequency employed. Plasma control subroutine 790 also includes program code for turning on and setting/adjusting the power levels applied to the magnetron or other microwave source used in the present invention. Similarly to the previously described chamber component subroutines, the plasma control subroutine 790 is invoked by the chamber manager subroutine 777a.

The above description is mainly for illustrative purposes, and other equipment such as electron cyclotron resonance (ECR) plasma CVD devices, induction-coupled RF high-density plasma CVD devices, or the like may be used with the present invention to provide upgraded apparatus. Additionally, variations of the above-described system, such as variations in pedestal design, heater design, RF power frequencies, location of RF power connections and others are possible. For example, the wafer could be supported and heated by quartz lamps. It should be recognized that the present invention is not necessarily limited to use with or retrofitting of any specific apparatus. Rather it should be apparent to those of skill in the art upon reviewing the above description that many variations of the present invention may be achieved. By way of example, the dual remote plasma embodiment may be employed to efficiently etch a substrate or to clean the apparatus. The scope of the invention should, therefore, be determined not with reference to the above description, but should instead be determined with reference to the appended claims, along with the full scope of equivalents to which such claims are entitled.

## Claims

1. A method for presenting ions into a process chamber, said method comprising:
forming first and second plasmas remotely with respect to said process chamber, said first plasma having a first plurality of reactive radicals associated therewith, and said second plasma having a second plurality of reactive radicals associated therewith;
flowing said first and second reactive radicals into said process chamber, with said first reactive radicals defining a first flow and said second reactive radicals defining a second flow; and
mixing said first and second flows after entering said process chamber.

2. The method as recited in claim 1 wherein before mixing said first and second flows, said first and second flows are spaced apart.

3. The method as recited in claim 1 wherein forming first and second plasmas remotely with respect to said process chamber includes concurrently forming first and second plasmas.

4. The method as recited in claim 1 wherein flowing said first and second reactive radicals into said process chamber includes dividing said first flow into a plurality of streams and dividing said second flow into a plurality of tributaries.

5. The method as recited in claim 1 wherein flowing said first and second reactive radicals into said process chamber includes dividing said first flow into a plurality of parallel streams and dividing said second flow into a plurality of parallel tributaries.

6. The method as recited in claim 1 wherein flowing said first and second reactive radicals into said process chamber includes surrounding said first flow with said second flow, with said first and second flow being spaced apart before mixing said first and second flows.

7. The method as recited in claim 1 wherein said first plurality of radicals includes a silicon atom and said second plurality of radicals includes a nitrogen atom.

8. The method as recited in claim 1 wherein said process chamber includes an intake port, an entry aperture and a processing area, spaced apart from both said intake port and said entry aperture, with flowing said first and second reactive radicals into said process chamber further including passing said first flow through said intake port and onto said processing area, passing said second flow through said entry aperture and onto said processing area, with both said first and second flows being spaced apart until reaching said processing area.

9. The method as recited in claim 1 wherein said process chamber is in fluid communication with a plasma generating device wherein forming a first and second plasma includes supplying first and second reactive gases to said plasma generating, with said first plurality of reactive radicals being associated with said first reactive gas and said second plurality of reactive radicals being associated with said second reactive gas, with said first reactive gas including a silicon source and said second reactive gas including a nitrogen source.

10. A deposition apparatus, including a process chamber; means, in fluid communication with said process chamber, for forming a first and second plasma remotely with respect to said process chamber, said first plasma having a first plurality of reactive radicals associated therewith, and said second plasma having a second plurality of reactive radicals associated therewith; means, in fluid communication with said process chamber, for flowing said first and second reactive radicals into said process chamber, with said first reactive radicals defining a first flow and said second reactive radicals defining a second flow; and means, coupled to said process chamber, for mixing said first and second flows after entering said process chamber.

11. The apparatus as recited in claim 10 wherein said means for forming first and second plasmas remotely includes means for concurrently forming said first and second plasmas remotely.

12. The apparatus as recited in claim 10 wherein said means for mixing includes first and second fluid distribution plates, each of which includes opposed major surfaces and a plurality of throughways extending between said opposed major surfaces, said first fluid distribution plate having a plurality of channels formed therein with a first subset of said plurality of throughways associated with said first fluid distribution plate being in fluid communication with said plurality of channels, and the remaining throughways associated with said first distribution plate, defining a second subset, being isolated from said plurality of channels, with a first subgroup of said throughways associated with said second fluid distribution plate being in fluid communication with said first subset, with the remaining throughways associated with said second distribution plate being in fluid communication with said second subset.

13. The apparatus as recited in claim 10 wherein said fluid distribution system includes a showerhead comprising first and second fluid distribution plates, with said first fluid distribution plate having opposed major surfaces, with a plurality of spaced-apart channel walls extending from one of said opposed major surfaces, away from the remaining major surface, with each of said plurality of channel walls enclosing a region of said one of said opposed major surfaces, defining a conduit, with an area of said one of said opposed major surfaces between adjacent channel walls defining a channel region, with a subset of said channel regions having a throughway placing said opposed major surfaces in fluid communication, and said region associated with said conduit having a pass-through extending between said opposed major surfaces, said second fluid distribution plate having opposing surfaces, with a plurality of apertures formed therein extending between said opposing surfaces, with each of said plurality of apertures of a subset arranged to superimpose one of said plurality of conduits upon said first and second fluid distribution plates being placed adjacent to one another, with each of said plurality of apertures associated with a subgroup being arranged to superimpose one of said plurality of channel regions.

14. The apparatus as recited in claim 12 wherein said fluid distribution system includes a fluid distribution manifold having a first conduit in fluid communication with both said waveguide system and said first subset, and a second conduit in fluid communication with both said waveguide system said second subset while being isolated from both said first conduit and said first subset.

15. The apparatus as recited in claim 14 wherein said waveguide system includes a pair of waveguides, one of which is in fluid communication with said source of said first plasma and said first conduit, with the remaining waveguide being in fluid communication with said second conduit.

16. An deposition apparatus, comprising a process chamber having an intake port and an entry aperture; a source of a first plasma having a first plurality of reactive radicals; a source of a second plasma having a second plurality of reactive radicals; a pump system in fluid communication with both said source of said first plasma and said source of said second plasma, said pump system connected to create first and second flows, with said first flow including said first plurality of reactive radicals and said second flow including said second plurality of reactive radicals; and a waveguide system in fluid communication with both said intake port and said entry aperture; and a fluid distribution system in fluid communication with said waveguide system.

17. The apparatus as recited in claim 16 wherein said fluid distribution system includes first and second fluid distribution plates, each of which includes opposed major surfaces and a plurality of throughways extending between said opposed major surfaces, said first fluid distribution plate having a plurality of channels formed therein with a first subset of said plurality of throughways associated with said first fluid distribution plate being in fluid communication with said plurality of channels, and the remaining throughways associated with said first distribution plate, defining a second subset, being isolated from said plurality of channels, with a first subgroup of said throughways associated with said second fluid distribution plate being in fluid communication with said first subset, with the remaining throughways associated with said second distribution plate being in fluid communication with said second subset.

18. The apparatus as recited in claim 16 wherein said fluid distribution system includes first and second fluid distribution plates, each of which has opposed major surfaces, a plurality of throughways and a plurality of apertures, with each of said plurality of throughways extending between a pair of said plurality of apertures, with each of the apertures of said pair being disposed in differing opposed major surfaces, said first fluid distribution plate having a plurality of channels formed therein with a first subset of said plurality of throughways of said first fluid distribution plate being in fluid communication with said plurality of channels, with the remaining throughways of said subset being isolated from said plurality of channels, and a first subgroup of said throughways of said second fluid distribution plate being in fluid communication with said first subset, with the remaining throughways associated with said second distribution plate being in fluid communication with said second subset.

19. The apparatus as recited in claim 17 wherein said fluid distribution system includes a fluid distribution manifold having a first conduit in fluid communication with both said waveguide system and said first subset, and a second conduit in fluid communication with both said waveguide system said second subset while being isolated from both said first conduit and said first subset.

20. The apparatus as recited in claim 19 wherein said waveguide system includes a pair of waveguides, one of which is in fluid communication with said source of said first plasma and said first conduit, with the remaining waveguide being in fluid communication with said second conduit.

21. The apparatus as recited in claim 15 further including a controller operatively coupled to said pump system, said source of said first plasma, said source of said second plasma and said plasma source; and a memory, coupled to said controller, comprising a computer-readable medium having a computer-readable program embodied therein for directing operation of said apparatus, said computer-readable program including a set of computer instructions to be operated on by said controller to regulate the introduction of said first and second plurality of reactive radicals into said process chamber at a predetermined rate.
